# EUROPEAN PATENT APPLICATION

(11) **EP 2 244 312 A2**
(43) Date of publication of application: **27.10.2010**
(21) Application number: 09173895.5
(22) Date of filing: 23.10.2009
(51) Int. Cl.: H01L 33/50, H01L 25/075, H01L 33/54, H01L 33/60

(54) **Yellow light emitting diode and light emitting device having the same**

(30) Priority: 21.04.2009 CN 200910301732
(71) Applicant: Foxsemicon Integrated Technology, Inc., Taiwan 350 (TW)
(72) Inventor: Akutsu, Nakao, Miao-Li Hsinen, Taiwan 350 (TW); Lai, Chih-Ming, Miao-Li Hsinen, Taiwan 350 (TW)
(74) Representative: Stuttard, Garry Philip

(57) **Abstract**

An exemplary yellow light emitting diode (LED) (10) includes a substrate (11), a LED die (12), a phosphor layer (13) and an encapsulant (14). The LED die (12) is arranged on the substrate (11) and comprises an indium gallium aluminum nitride represented by the formula InₓGayAl_{z}N , wherein x+y+z=1, 0≦x≦1, 0≦y≦1 and 0≦z≦1. The phosphor layer (13) is a yttrium aluminum garnet phosphor layer configured on the light path of the LED die (12). The phosphor layer (13) has a thickness of more than 250 micron. The encapsulant (14) covers the LED die (12) and the phosphor layer (13).

## Description

The present disclosure generally relates to light emitting diodes and, particularly, to a yellow light emitting diode using a phosphor layer.

Light emitting diodes (LEDs) have recently been used extensively as light sources for illumination devices due to their high luminous efficiency, low power consumption and long work life.

Generally, a yellow LED mainly includes an aluminum indium gallium phosphide with an emission wavelength in a range from about 560 to 590 nanometers. However, due to the aluminum doping and indium doping in the phosphide, crystal lattice mismatch conditions occur thereby decreasing luminous efficiency thereof. Further, due to poor thermal resistance of the aluminum indium gallium phosphide, a yellow LED using the same has unsatisfactory color accuracy under high working temperature.

Therefore, what is needed is a yellow light emitting diode with high luminous efficiency and color accuracy.

The present invention relates to a yellow light emitting diode (LED). According to a preferred embodiment of the present invention, the yellow light emitting diode (LED) includes a substrate, a LED die, a phosphor layer and a encapsulant. The LED die is arranged on the substrate for emitting light along a light path. The LED die includes an indium gallium aluminum nitride represented by the formula InₓGa_{y}Al_{z}N, wherein x+y+z=1, 0 ≦x≦1,0≦y≦1, and 0≦z≦1. The phosphor layer is arranged on the light path of the LED die. The phosphor layer is a yttrium aluminum garnet phosphor layer and has a thickness of more than 250 micron. The encapsulant covers the LED die and the phosphor layer.

Many aspects of the present yellow light emitting diode can be better understood with reference to the following drawings. The components in the drawings are not necessarily drawn to scale, the emphasis instead being placed upon clearly illustrating the principles of the present yellow light emitting diode. Moreover, in the drawings, like reference numerals designate corresponding parts throughout the several views.

FIG. 1 is a cross-sectional view of a yellow light emitting diode, according to a first embodiment.

FIG. 2 is a cross-sectional view of a yellow light emitting diode, according to a variation of the first embodiment.

FIG. 3 is a cross-sectional view of a yellow light emitting diode, according to another variation of the first embodiment.

FIG. 4 is a schematic, top view of a light emitting device, according to a second embodiment.

FIG. 5 is a schematic, top view of a light emitting device, according to a third embodiment.

FIG. 6 is a schematic, top view of a light emitting device, according to a fourth embodiment.

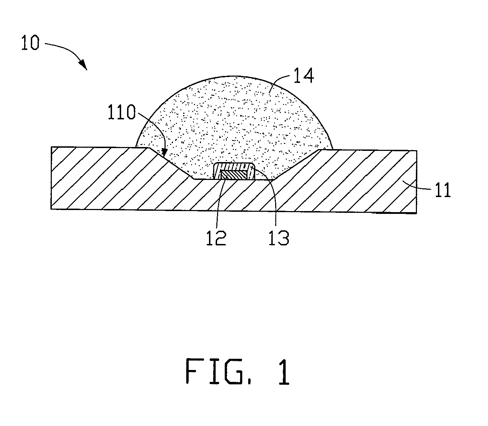

Referring to FIGS. 1, a yellow light emitting diode (LED) 10, in accordance with a first embodiment, is provided. The yellow light emitting diode 10 includes a substrate 11, a LED die 12, a phosphor layer 13 and an encapsulant 14.

The substrate 11 includes a reflective cup 110 for receiving the LED die 12. In an exemplary embodiment, the reflective cup 110 defines a frustoconical recess. The reflective cup 110 is capable of reflecting light emitted from the LED die 12 to an interior of the encapsulant 14.

The LED die 12 is arranged on the substrate 11 and for emitting light along a light path. Concretely, the LED die 12 is received in the reflective cup 110 and mounted on a flat bottom surface thereof. The LED die 12 includes an indium gallium aluminum nitride represented by the formula InₓGa_{y}Al_{z}N (x+y+z=1, 0≦x≦ 1 , 0≦y≦1 , 0≦z≦1). In an exemplary embodiment, an emission wavelength of the LED die is in a range from 260 to 500 nanometers. Further, the emission wavelength of the LED die can be in a range from 380 to 480 nanometers.

The phosphor layer 13 is formed on an outer surface of the LED die 12, thereby covering whole of the LED die 12. The phosphor layer 13 is an yttrium aluminum garnet (YAG) phosphor layer and has a thickness of more than 250 microns. The phosphor layer 13 is for emitting wavelength conversion light by receiving the excitation light emitted from the LED die 12. In order to ensure the excitation light emitted by the LED die 12 are absorbed by the phosphor layer 13 as much as possible, the thickness of the phosphor layer 13 can be thicker than 250 microns, for example more than 400 microns. In an exemplary embodiment, excitation wavelength of the phosphor layer 13 is in a range from 560 to 590 nanometers. The phosphor layer 13 need not be absolutely uniform in the micro scale. As such, the above mentioned thickness limitations means that a minimum thickness of the phosphor layer 13 may from more than 250 microns to more than 400 microns.

The encapsulant 14 is arranged on the substrate 11 and covers the LED die 12 and the phosphor layer 13, thereby preventing the LED die 12 and the phosphor layer 13 from being destroyed by external factors. The encapsulant 14 has a top light emitting surface 140 for outputting light to the exterior thereof. In an exemplary embodiment, the light emitting surface 140 is a circular cambered surface, with an exterior convexity of the circular cambered surface facing away from the substrate 11. The light emitting surface 140 can also have other shapes according to different light extraction requirements.

Because the indium gallium aluminum nitride has a thermal resistance better than aluminum indium gallium phosphide and the yttrium aluminum garnet phosphor layer has a light conversion efficiency near 90%, the yellow light emitting diode 10 has satisfactory light accuracy and high luminous efficiency.

It is to be said that, the phosphor layer 13 is not limited to be formed on the outer surface of the LED die 12, as long as the phosphor layer 13 is arranged on the light path of the LED die 12.

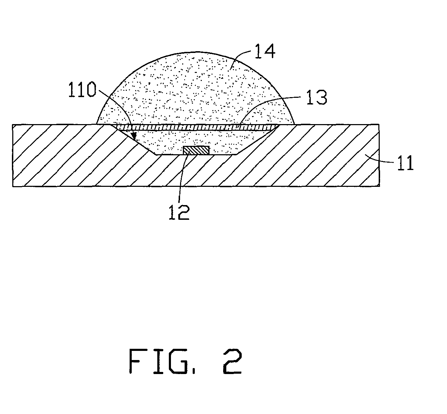

Referring to FIG. 2, the phosphor layer 13 can also be arranged at a top opening of the reflecting cup 110. The phosphor layer 13 is parallel to the flat bottom surface of the reflecting cup 110 and covers the top opening of the reflecting cup 110.

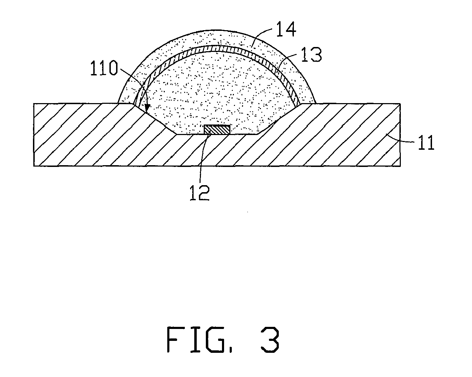

Referring to FIG. 3, the phosphor layer 13 can also be arranged at a top opening of the reflecting cup 110. The phosphor layer 13 is parallel to the light emitting surface 140 of the encapsulant 14 and covers the top opening of the reflecting cup 110.

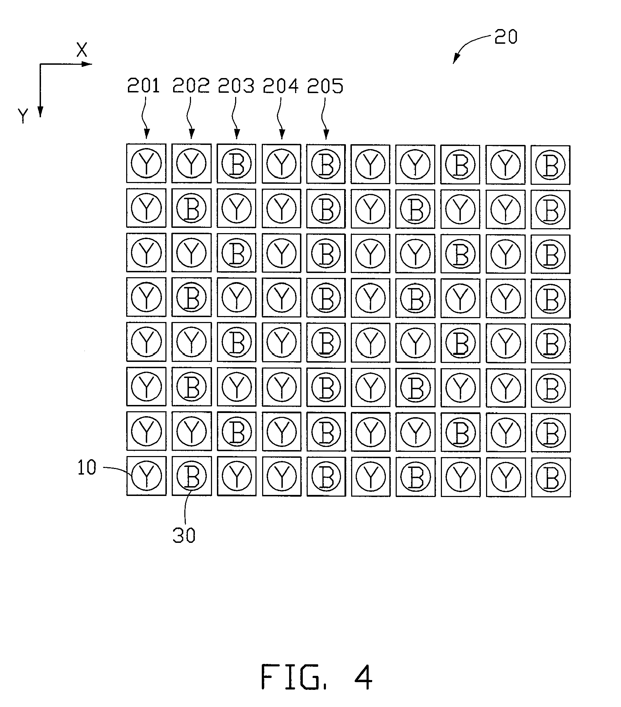

In figures 4, 5, 6 B stands for a blue light emitting diode, R stands for a red light emitting diode, G stands for a green light emitting diode, and Y stands for a yellow light emitting diode. Referring to FIG. 4, a light emitting device 20, in accordance with a second embodiment, is provided. The light emitting device 20 includes a plurality of yellow light emitting diodes 10 and a plurality of blue light emitting diodes 30. The yellow light emitting diodes 10 and blue light emitting diodes 30 are arranged together in an array. The light emitting device 20 includes several light emitting diode rows (rows 201, 202, 203, 204 and 205) each of which extends along y-direction as illustrated in FIG. 4.

Row 201 includes a plurality of yellow light emitting diodes 10. Row 202 includes a plurality of yellow light emitting diodes 10 and blue light emitting diodes 30 arranged in a sequence of "Y, B, Y, B...". Row 203 includes a plurality of yellow light emitting diodes 10 and blue light emitting diodes 30 arranged in a sequence of "B, Y, B, Y...". Row 204 includes a plurality of yellow light emitting diodes 10. Row 205 includes a plurality of blue light emitting diodes 30. In an exemplary embodiment, an emission wavelength of the blue light emitting diodes 30 is in a range from 420 to 480 nanometers. The amount ratio of the yellow light emitting diodes 10 to the blue light emitting diodes 30 is 3:2, and the light emitted from the light emitting device 20 appears white.

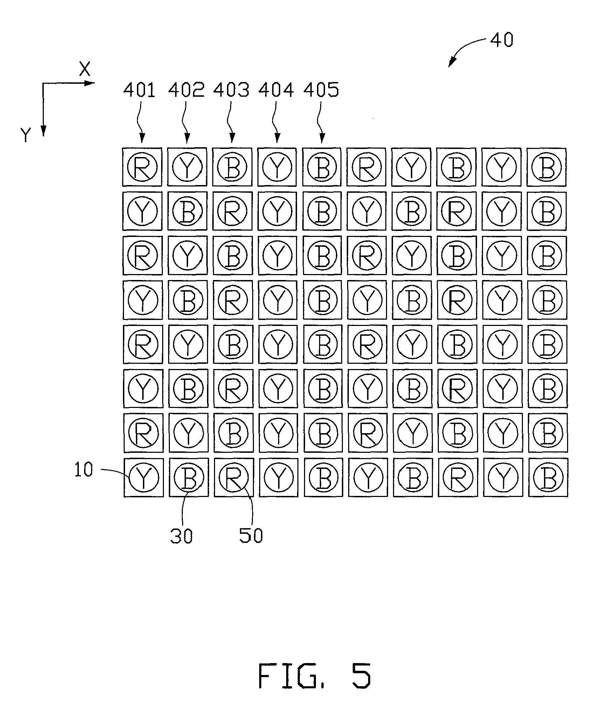

Referring to FIG. 5, a light emitting device 40, in accordance with a third embodiment, is provided. The light emitting device 40 includes a plurality of yellow light emitting diodes 10, a plurality of blue light emitting diodes 30, and a plurality of red light emitting diodes 50 arranged together in an array. The light emitting device 40 includes several light emitting diode rows (rows 401, 402, 403, 404 and 405) each of which extends along y-direction as illustrated in FIG. 5.

Row 401 includes a plurality of yellow light emitting diodes 10 and a plurality of red light emitting diodes 50 arranged in a sequence of "R, Y, R, Y...". Row 402 includes a plurality of yellow light emitting diodes 10 and blue light emitting diodes 30 arranged in a sequence of "Y, B, Y, B...". Row 403 includes a plurality of blue light emitting diodes 30 and a plurality of red light emitting diodes 50 arranged in a sequence of "B, R, B, R...". Row 404 includes a plurality of yellow light emitting diodes 10. Row 405 includes a plurality of blue light emitting diodes 30. The amount ratio of yellow light emitting diodes 10 to blue light emitting diodes 30 to red light emitting diodes 50 is 2:2:1, and light emitted from the light emitting device 40 appears white. Due to that the light emitting device 40 includes a plurality of red light emitting diodes 50 in addition, the light emitting device 40 has higher color rendering ability than the light emitting device 20.

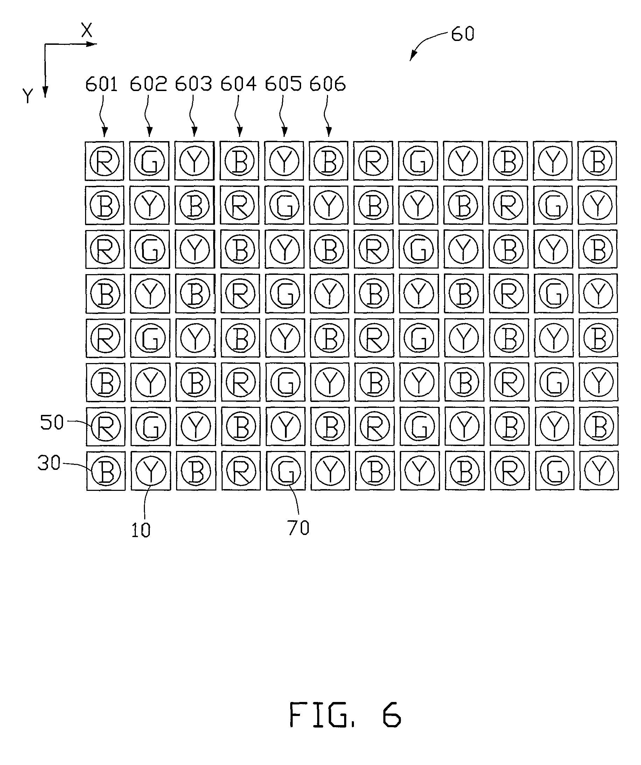

Referring to FIG. 6, a light emitting device 60, in accordance with a fourth embodiment, is provided. The light emitting device 60 includes a plurality of yellow light emitting diodes 10, a plurality of blue light emitting diodes 30, a plurality of red light emitting diodes 50 and a plurality of green light emitting diodes 70 arranged together in an array. The light emitting device 60 includes several light emitting diode rows (rows 601, 602, 603, 604, 605 and 605) each of which extends along y-direction as illustrated in FIG. 6.

Row 601 includes a plurality of red light emitting diodes 50 and a plurality of blue light emitting diodes 30 arranged in a sequence of "R, B, R, B...". Row 602 includes a plurality of green light emitting diodes 70 and yellow light emitting diodes 10 arranged in a sequence of "G, Y, G, Y...". Row 603 includes a plurality of yellow light emitting diodes 10 and blue light emitting diodes 30 arranged in a sequence of "Y, B, Y, B...". Row 604 includes a plurality of blue light emitting diodes 30 and a plurality of red light emitting diodes 50 arranged in a sequence of "B, R, B, R...". Row 605 includes a plurality of yellow light emitting diodes 10 and green light emitting diodes 70 arranged in a sequence of "Y, G, Y, G...". Row 606 includes a plurality of yellow light emitting diodes 10 and blue light emitting diodes 30 arranged in a sequence of "B, Y, B, Y...". The amount ratio of yellow light emitting diodes 10 to blue light emitting diodes 30 to red light emitting diodes 50 to green light emitting diode 70 is 2:2:1:1, and light emitted from the light emitting device 60 appears white. Due to the light emitting device 60 including a plurality of green light emitting diodes 70, the light emitting device 60 has higher color rendering ability than the light emitting device 40.

Finally, it is to be understood that the above-described embodiments are intended to illustrate rather than limit the invention. Variations may be made to the embodiments without departing from the spirit of the invention as claimed. The above-described embodiment illustrates the scope of the invention but do not restrict the scope of the invention.

## Claims

1. A yellow light emitting diode (LED) comprising:
a substrate;
a LED die arranged on the substrate for emitting light along a light path, wherein the LED die comprises an indium gallium aluminum nitride represented by the formula InₓGa_{y}Al_{z}N, wherein x+y+z=1, 0≦x≦1,0≦y≦1 and 0≦z≦1;
a phosphor layer arranged on the light path of the LED die, wherein the phosphor layer is an yttrium aluminum garnet phosphor layer and has a thickness of more than 250 micron; and
an encapsulant covering the LED die and the phosphor layer.

2. A yellow LED as claimed in claim 1, wherein the substrate comprises a reflective cup for receiving the LED die, wherein the reflective cup defines a frustoconical recess and the LED die is mounted on a bottom surface of the reflective cup, wherein the phosphor layer is formed on an outer surface of the LED die.

3. A yellow LED as claimed in claim 1, wherein the substrate comprises a reflective cup for receiving the LED die, wherein the reflective cup defines a frustoconical recess and the LED die is mounted on a bottom surface of the reflective cup, wherein the phosphor layer is arranged at a top opening of the reflecting cup and is parallel to the bottom surface and covers the top opening of the reflecting cup.

4. A yellow LED as claimed in any preceding claim, wherein the encapsulant comprises a light emitting surface for outputting light from the LED die to the exterior of the encapsulant, wherein the substrate comprises a reflective cup for receiving the LED die and the LED die is arranged on a bottom of the reflective cup, wherein the phosphor layer is arranged at a top opening of the reflecting cup and the phosphor layer is parallel to the light emitting surface and covers the top opening of the reflecting cup.

5. A yellow LED as claimed in any preceding claim wherein the phosphor layer has a thickness of more than 400 micron.

6. A yellow LED as claimed in any preceding claim wherein an excitation wavelength of the phosphor layer is in the range 560 to 590 nanometers.

7. A yellow LED as claimed in any preceding claim wherein an emission wavelength of the LED die is in the range 260 to 500 nanometers.

8. A yellow LED as claimed in claim 7, wherein the emission wavelength of the LED die is in the range 380 to 480 nanometers.

9. A light emitting device comprising:
a plurality of yellow LEDs each having a substrate, a LED die for emitting light along a light path, a phosphor layer and an encapsulant, wherein the LED die is arranged on the substrate and comprises an indium gallium aluminum nitride represented by the formula InₓGa_{y}Al_{z}N wherein x+y+z=1, 0≦x≦1, 0≦y≦1and 0≦z≦1, wherein the phosphor layer is a yttrium aluminum garnet phosphor layer arranged on the light path of the LED die and has a thickness of more than 250 micron, wherein the encapsulant covers the LED die and the phosphor layer; and
a plurality of blue LEDs;
wherein the yellow LEDs and the blue LEDs are in an amount ratio of 3:2.

10. A light emitting device as claimed in claim 9, wherein the substrate comprises a reflective cup for receiving the LED die, wherein the reflective cup defines a frustoconical recess and the LED die is mounted on a bottom surface of the reflective cup, wherein the phosphor layer is formed on an outer surface of the LED die.

11. A light emitting device as claimed in claim 9, wherein the substrate comprises a reflective cup for receiving the LED die and the reflective cup defines a frustoconical recess, wherein the LED die is mounted on a bottom surface of the reflective cup and the phosphor layer is arranged at a top opening of the reflecting cup, wherein the phosphor layer is parallel to the bottom surface and covers the top opening of the reflecting cup.

12. A light emitting device as claimed in claim 9, wherein the encapsulant comprises a light emitting surface for outputting light from the LED die to the exterior of the encapsulant, wherein the substrate comprises a reflective cup for receiving the LED die and the LED die is mounted on a bottom of the reflective cup, wherein the phosphor layer is arranged at a top opening of the reflecting cup, and the phosphor layer is parallel to the light emitting surface and covers the top opening of the reflecting cup.

13. A light emitting device as claimed in claim 9, wherein the phosphor layer has a thickness more than 400 micron.

14. A light emitting device as claimed in claim 9, wherein an emission wavelength of the blue LEDs is in the range 420-480 nanometers.

15. A light emitting device comprising:
a plurality of yellow LEDs each having a substrate, a LED die for emitting light along a light path, a phosphor layer and an encapsulant, wherein the LED die is arranged on the substrate and comprises an indium gallium aluminum nitride represented by the formula InₓGa_{y}Al_{z}N, wherein x+y+z=1, 0≦x≦1, 0≦y≦1 and 0≦z≦1, wherein the phosphor layer is a yttrium aluminum garnet phosphor layer arranged on the light path of the LED die and has a thickness of more than 250 micron, wherein the encapsulant covers the LED die and the phosphor layer;
a plurality of blue LEDs; and
at least one red LED, wherein the yellow LEDs, the blue LEDs and the at least one red LED are in an amount ratio of 2:2:1.

16. A light emitting device as claimed in claim 15 further comprising at least one green LED, wherein the yellow LEDs, the blue LEDs, the at least one red LED and the at least one green LED are in an amount ratio of 2:2:1:1.

17. A light emitting device as claimed in claim 15 or 16, wherein the substrate comprises a reflective cup for receiving the LED die and the reflective cup defines a frustoconical recess, wherein the LED die is mounted on a bottom surface of the reflective cup and the phosphor layer is formed on an outer surface of the LED die.

18. A light emitting device as claimed in claim 15 or 16, wherein the substrate comprises a reflective cup for receiving the LED die and the reflective cup defines a frustoconical recess, wherein the LED die is mounted on a bottom surface of the reflective cup and the phosphor layer is arranged at a top opening of the reflecting cup, wherein the phosphor layer is parallel to the bottom surface and covers the top opening of the reflecting cup.

19. A light emitting device as claimed in claim 15, wherein the encapsulant comprises a light emitting surface for outputting light from the LED die to the exterior of the encapsulant, wherein the substrate comprises a reflective cup for receiving the LED die and the LED die is mounted on a bottom of the reflective cup, wherein the phosphor layer is arranged at a top opening of the reflecting cup and the phosphor layer is parallel to the light emitting surface and covers the top opening of the reflecting cup.

20. A light emitting device as claimed in any of claims 15 to 19, wherein the phosphor layer has a thickness of more than 400 micron.
